# EUROPÄISCHE PATENTANMELDUNG

(11) **EP 2 518 774 A2**
(43) Veröffentlichungstag der Anmeldung: **31.10.2012**
(21) Anmeldenummer: 12001997.1
(22) Anmeldetag: 21.03.2012
(51) Int. Cl.: H01L 31/02

(54) **Sicherungs-Vorrichtung für Photovoltaikmodule**

(30) Priorität: 22.03.2011 DE 102011014759
(71) Anmelder: Koch, Hans Joachim, 89584 Ehingen (DE); Koch, Benjamin Johannes, 88416 Ochsenhausen-Goppertshofen (DE); Neumann, Thomas, 87600 Kaufbeuren (DE)
(72) Erfinder: Koch, Hans Joachim, 89584 Ehingen (DE); Koch, Benjamin Johannes, 88416 Ochsenhausen-Goppertshofen (DE); Neumann, Thomas, 87600 Kaufbeuren (DE)
(74) Vertreter: Kiessling, Christian

(57) **Zusammenfassung**

Bei einer Sicherungs-Vorrichtung (100) für Photovoltaikmodule (110) mit photovoltaischen Flächenelementen, in denen Lichtenergie in elektrische Energie wandelbar und erzeugte elektrische Spannung an Ausgangsklemmen (120, 120') unterschiedlicher Polarität abgreifbar ist, wobei eine an den Ausgangsklemmen (120, 120') bereitstehende Gleichspannung in mindestens einem mit den Ausgangsklemmen (120, 120') verbundenen DC/AC-Wandlern (130) in eine Wechselspannung wandelbar ist, wird eine leichte Installierbarkeit bei hoher Effektivität dadurch erreicht, dass eine Schaltanordnung vorgesehen ist, die sowohl alle Ausgangsklemmen (120) positiver Polarität als auch alle Ausgangsklemmen (120') negativer Polarität bei einer Deaktivierung des DC/AC-Wandlers (130) elektrisch mit dem Erdpotential verbindet.

## Beschreibung

Die Erfindung betrifft eine Sicherungs-Vorrichtung für Photovoltaikmodule mit photovoltaischen Flächenelementen, in denen Lichtenergie in elektrische Energie wandelbar und erzeugte elektrische Spannung an Ausgangsklemmen unterschiedlicher Polarität abgreifbar ist, wobei eine an den Ausgangsklemmen bereitstehende Gleichspannung in mindestens einem mit den Ausgangsklemmen verbundenen DC/AC-Wandlern in eine Wechselspannung wandelbar ist. Der DC/AC-Wandler kann dabei extern deaktivierbar sein. Sicherungs-Vorrichtungen der eingangs genannten Art werden im Stand der Technik verwendet, um Photovoltaikelemente im Bedarfsfall wie etwa bei Brand durch Kurzschluss spannungsfrei zu schalten, da die Spannungen in Reihe geschalteter, auf Wohnhausdächern in handelsüblichen Solarpaneelen angeordneter sonnenbeschienener Photovoltaikelemente sich zu so hohen Voltzahlen aufaddieren, dass herkömmliche Löschmaßnahmen das Feuerwehrpersonal der Gefahr eines elektrischen Schlages aussetzen, da ein von einem Photovoltaikelement ausgehender elektrischer Strom durch einen wasserführenden Schlauch über einen Feuerwehrmann in den Boden (Erdpotential) fließen kann. Die bekannten Vorrichtungen weisen indes den Nachteil auf, dass ein sicherer Betrieb nicht gewährleistet ist, so dass die Feuerwehr in der Regel mit Photovoltaikpaneelen versehene Wohnhäuser bei Brand kontrolliert abbrennen lässt, um das eigene Personal zu schützen.

Aufgabe der Erfindung ist es deshalb, eine Sicherungs-Vorrichtung für Photovoltaikmodule zu schaffen, die kostengünstig und leicht installierbar ist, und deren Effektivität und damit Sicherheit gegenüber den bekannten Vorrichtungen verbessert ist.

Für eine Sicherungs-Vorrichtung der eingangs genannten Art wird diese Aufgabe gemäß einem ersten Aspekt der Erfindung dadurch gelöst, dass eine Schaltanordnung vorgesehen ist, die sowohl alle Ausgangsklemmen positiver Polarität als auch alle Ausgangsklemmen negativer Polarität bei einer Deaktivierung des allgemeinen Stromnetzes elektrisch mit dem Erdpotential verbindet.

Gemäß einem alternativen zweiten Aspekt der Erfindung wird diese Aufgabe dadurch gelöst, dass eine Schaltanordnung vorgesehen ist, die sowohl alle Ausgangsklemmen positiver Polarität als auch alle Ausgangsklemmen negativer Polarität bei einer Deaktivierung des DC/AC-Wandlers elektrisch mit dem Erdpotential verbindet.

Bevorzugte Ausführungsformen der Erfindung sind Gegenstand der Unteransprüche der jeweils unabhängigen Patentansprüche 1 und 2.

Bei der erfindungsgemäßen Sicherungs-Vorrichtung wird mit Hilfe der Merkmalskombination der jeweiligen kennzeichnenden Teile der unabhängigen Patentansprüche 1 und 2 erreicht, dass mit robusten einfachen Mitteln auf zuverlässige Weise eine Potentialgleichschaltung auf Erde aller Ausgangsklemmen und damit eine Spannungsfreiheit bzw. annähernde Spannungsfreiheit zwischen allen Ausgangsklemmen eines oder einer Mehrzahl von Photovoltaikmodulen erzeugbar ist. Ein Stromfluss zwischen den Ausgangsklemmen ist dadurch genauso ausgeschlossen wie ein Stromfluss zwischen einer Ausgangsklemme und dem Erdpotential.

Gemäß einer ersten bevorzugten Ausführungsform der erfindungsgemäßen Vorrichtung ist vorgesehen, dass eine Mehrzahl von Photovoltaikmodulen in Reihe geschaltet ist, wobei eine positive Ausgangsklemme eines ersten Photovoltaikmoduls elektrisch mit einer negativen Ausgangsklemme eines benachbarten Photovoltaikmoduls verbunden ist und die elektrische Verbindung dieser Ausgangsklemmen über eine gemeinsame Leitung mit dem Erdpotential verbindbar ist.

Die Schaltanordnung ist vorzugsweise als Kipp-Schaltung ausgeführt derart, dass sie in einem ersten Zustand in einem Standardbetrieb eine elektrische Verbindung zwischen den Ausgangsklemmen der Photovoltaikmodule und dem DC/AC-Wandler herstellt und in einem gekippten zweiten Zustand alle Ausgangsklemmen positiver Polarität als auch alle Ausgangsklemmen negativer Polarität bei einer Deaktivierung des allgemeinen Stromnetzes elektrisch mit Erde (Erdpotential) verbindet.

Gemäß einer bevorzugten Ausführungsform kann dabei vorgesehen sein, dass die Kipp-Schaltung mit mindestens einer Phase sowie dem Nullleiter des allgemeinen Stromnetzes verbunden ist und bei einem Verlust an Potentialdifferenz zwischen der einen Phase und dem Nullleiter ein Kippen der Schaltung in den zweiten Zustand bewirkt.

Gemäß einer alternativen Ausführungsform kann vorgesehen sein, dass die Kipp-Schaltung mit mindestens einer Phase sowie dem Nullleiter des allgemeinen Stromnetzes verbunden ist und eine Deaktivierung des Stromnetzes über einen Verlust an Potentialdifferenz zwischen den Ausgangsklemmen der einen Phase und dem Nullleiter sensiert.

Gemäß einer wichtigen Ausführungsform kann vorgesehen sein, dass ein Signal betreffend eine Präsenz der mindestens einen Phase und des Nullleiters des allgemeinen Stromnetzes auf die DC-Leitungen der Schaltanordnung aufmoduliert ist, um an den Ausgangsklemmen eines Photovoltaikmoduls abgreifbar vorzuliegen.

Gemäß dem zweiten Aspekt der vorliegenden Erfindung ist die Kipp-Schaltung mit dem Ausgang des DC/AC-Wandlers verbunden und bewirkt bei einem Verlust an Potentialdifferenz zwischen den Ausgangsklemmen des DC/AC-Wandlers ein Kippen der Schaltung in den zweiten Zustand. Alternativ kann dabei vorgesehen sein, dass die Kipp-Schaltung eine Deaktivierung des DC/AC-Wandlers über einen Verlust an Potentialdifferenz zwischen den Ausgangsklemmen des DC/AC-Wandlers lediglich sensiert.

Gemäß einer weiteren bevorzugten Ausführungsform beider Aspekte der erfindungsgemäßen Vorrichtung ist vorgesehen, dass die Schaltanordnung mindestens ein Schaltelement enthält, das in einem ersten Zustand elektrischen Strom einer Ausgangsklemme eines Photovoltaikmoduls mit einer Eingangsklemme des DC/AC-Wandlers verbindet und in einem zweiten Zustand elektrischen Strom einer Ausgangsklemme eines Photovoltaikmoduls mit dem Erdpotential verbindet. Vorzugsweise kann dabei jedem Photovoltaikelement ein entsprechendes Schaltelement zugeordnet sein.

Gemäß einer wichtigen Ausführungsform beider Aspekte der erfindungsgemäßen Vorrichtung ist vorgesehen, dass die Verbindung zur dem Erdpotential über eine elektrische Verbindung zu einem elektrisch leitenden Montagegestell der Photovoltaikmodule hergestellt ist.

Das Schaltelement kann von einem herkömmlichen elektrischen Relais oder alternativ von einem Halbleiterschaltelement gebildet sein, wobei im letzteren Fall sowohl ein Transistor als auch ein Tyristor als Halbleiterschaltelement Verwendung finden können.

Der Stromwandler der vorliegenden Erfindung ist in der Regel ein DC/AC-Wandler. Alternativ kann der Stromwandler auch als DC/DC-Wandler ausgelegt sein und/oder auch noch weitere Funktionen bereitstellen

Die erfindungsgemäße Vorrichtung wird im Folgenden anhand einer bevorzugten Ausführungsform erläutert, die in der Figur der Zeichnung dargestellt ist. Darin zeigt:

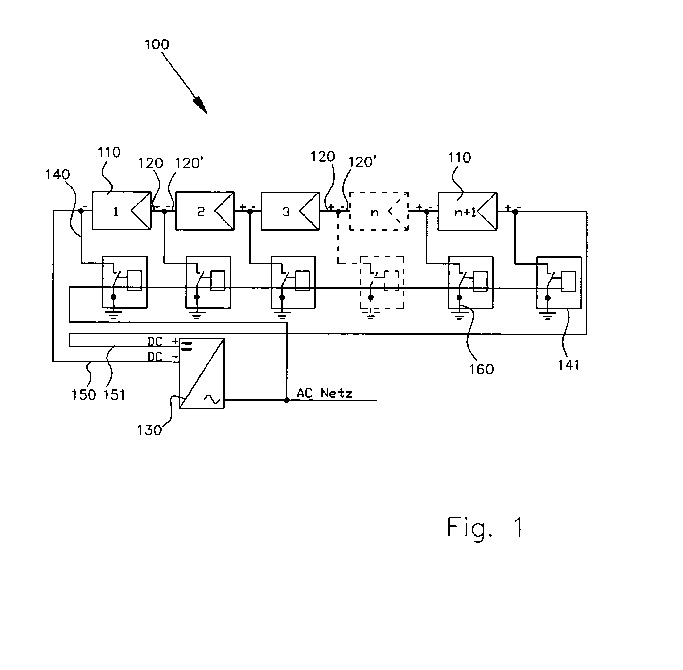

- Fig. 1: eine bevorzugte Ausführungsform der erfindungsgemäßen Sicherungs-Vorrichtung in Form einer schematischen Schaltanordnung.

Die in Figur 1 dargestellte erfindungsgemäße Sicherungs-Vorrichtung (100) für Photovoltaikmodule (110) enthält photovoltaische Flächenelemente, in denen Lichtenergie in elektrische Spannung wandelbar ist und erzeugte elektrische Spannung an Ausgangsklemmen (120, 120') unterschiedlicher Polarität abgreifbar ist.

Eine an den Ausgangsklemmen (120, 120') bereitstehende Gleichspannung ist dabei in einem mit den Ausgangsklemmen (120, 120') verbundenen DC/AC-Wandler (130) in eine Wechselspannung wandelbar.

In der dargestellten Schaltanordnung sind sowohl alle Ausgangsklemmen (120) positiver Polarität als auch alle Ausgangsklemmen (120') negativer Polarität bei einer Deaktivierung des allgemeinen Stromnetzes elektrisch mit dem Erdpotential verbindbar.

Dargestellt ist eine Mehrzahl in Reihe geschalteter Photovoltaikmodule (110), wobei eine positive Ausgangsklemme (120) eines ersten Photovoltaikmoduls (110) elektrisch mit einer negativen Ausgangsklemme (120') eines benachbarten Photovoltaik-moduls (110) verbunden ist und wobei die elektrische Verbindung dieser Ausgangsklemmen (120, 120') über eine gemeinsame Leitung (140) mit dem Erdpotential verbindbar ist.

Die Schaltanordnung ist als Kipp-Schaltung ausgeführt und stellt in einem ersten Zustand in einem Standardbetrieb eine elektrische Verbindung zwischen den Ausgangsklemmen (120, 120') der Photovoltaikmodule (110) und dem DC/AC-Wandler (130) her. In einem gekippten zweiten Zustand verbindet die Kipp-Schaltung (141) alle Ausgangsklemmen positiver Polarität (120) als auch alle Ausgangsklemmen (120') negativer Polarität bei einer Deaktivierung des allgemeinen Stromnetzes elektrisch mit Erde (Erdpotential).

Die Kipp-Schaltung (141) ist mit einer Phase sowie dem Nullleiter des allgemeinen Stromnetzes verbunden und bewirkt bei einem Verlust an Potentialdifferenz zwischen der einen Phase und dem Nullleiter ein Kippen der Schaltung in den zweiten Zustand.

Ein Signal betreffend eine Präsenz einer Spannung zwischen der einen Phase und dem Nullleiter des allgemeinen Stromnetzes ist auf die DC-Leitungen (150, 151) der Schaltanordnung aufmoduliert, um an den Ausgangsklemmen (120, 120') eines Photovoltaikmoduls (110) abgreifbar vorzuliegen.

Die Schaltanordnung enthält eine Mehrzahl von jeweils von einem Transistor gebildeten Schaltelementen (141), die in einem ersten Zustand elektrischen Strom einer Ausgangsklemme (120, 120') eines Photovoltaikmoduls (110) mit einer Eingangsklemme des DC/AC-Wandlers (130) verbindet und in einem zweiten Zustand elektrischen Strom einer Ausgangsklemme (120, 120') eines Photovoltaikmoduls (110) mit dem Erdpotential verbindet. Dabei ist jedem Photovoltaikelement (110) ein entsprechendes Schaltelement (141) zugeordnet.

Die Verbindung zum Erdpotential ist jeweils über eine elektrische Verbindungsleitung (160) zu einem elektrisch leitenden Montagegestell der Photovoltaikmodule (110) hergestellt.

Das oben erläuterte Ausführungsbeispiel der Erfindung dient lediglich dem Zweck eines besseren Verständnisses der durch die Ansprüche vorgegebenen erfindungsgemäßen Lehre, die als solche durch das Ausführungsbeispiel nicht eingeschränkt ist.

## Patentansprüche

1. Sicherungs-Vorrichtung (100) für Photovoltaikmodule (110) mit photovoltaischen Flächenelementen, in denen Lichtenergie in elektrische Energie wandelbar und erzeugte elektrische Spannung an Ausgangsklemmen (120, 120') unterschiedlicher Polarität abgreifbar ist, wobei eine an den Ausgangsklemmen (120, 120') bereitstehende Gleichspannung in mindestens einem mit den Ausgangsklemmen (120, 120') verbundenen DC/AC-Wandler (130) in eine Wechselspannung wandelbar ist, **dadurch gekennzeichnet, dass** eine Schaltanordnung vorgesehen ist, die sowohl alle Ausgangsklemmen (120) positiver Polarität als auch alle Ausgangsklemmen (120') negativer Polarität bei einer Deaktivierung des allgemeinen Stromnetzes elektrisch mit dem Erdpotential verbindet.

2. Sicherungs-Vorrichtung (100) für Photovoltaikmodule (110) mit photovoltaischen Flächenelementen, in denen Lichtenergie in elektrische Energie wandelbar und erzeugte elektrische Spannung an Ausgangsklemmen (120, 120') unterschiedlicher Polarität abgreifbar ist, wobei eine an den Ausgangsklemmen (120, 120') bereitstehende Gleichspannung in mindestens einem mit den Ausgangsklemmen (120, 120') verbundenen DC/AC-Wandler (130) in eine Wechselspannung wandelbar ist, **dadurch gekennzeichnet, dass** eine Schaltanordnung vorgesehen ist, die sowohl alle Ausgangsklemmen (120) positiver Polarität als auch alle Ausgangsklemmen (120') negativer Polarität bei einer Deaktivierung des DC/AC-Wandlers (130) elektrisch mit dem Erdpotential verbindet.

3. Vorrichtung nach einem der Ansprüche 1 oder 2, **dadurch gekennzeichnet, dass** eine Mehrzahl von Photovoltaikmodulen (110) in Reihe geschaltet ist, wobei eine positive Ausgangsklemme (120) eines ersten Photovoltaikmoduls (110) elektrisch mit einer negativen Ausgangsklemme (120') eines benachbarten Photovoltaikmoduls (110) verbunden ist und die elektrische Verbindung dieser Ausgangsklemmen (120, 120') über eine gemeinsame Leitung (140) mit dem Erdpotential verbindbar ist.

4. Vorrichtung nach einem der Ansprüche 1 bis 3, **dadurch gekennzeichnet, dass** die Schaltanordnung als Kipp-Schaltung (141) ausgeführt ist und in einem ersten Zustand in einem Standardbetrieb eine elektrische Verbindung zwischen den Ausgangsklemmen (120, 120') der Photovoltaikmodule (110) und dem DC/AC-Wandler (130) herstellt und in einem gekippten zweiten Zustand alle Ausgangsklemmen (120) positiver Polarität als auch alle Ausgangsklemmen (120') negativer Polarität bei einer Deaktivierung des allgemeinen Stromnetzes elektrisch bzw. Stromwandlers mit dem Erdpotential verbindet.

5. Vorrichtung nach Anspruch 4, **dadurch gekennzeichnet, dass** die Kipp-Schaltung mit mindestens einer Phase sowie dem Nullleiter des allgemeinen Stromnetzes verbunden ist und bei einem Verlust an Potentialdifferenz zwischen der einen Phase und dem Nullleiter ein Kippen der Schaltung in den zweiten Zustand bewirkt.

6. Vorrichtung nach Anspruch 4, **dadurch gekennzeichnet, dass** die Kipp-Schaltung mit mindestens einer Phase sowie dem Nullleiter des allgemeinen Stromnetzes verbunden ist und eine Deaktivierung des Stromnetzes über einen Verlust an Potentialdifferenz zwischen den Ausgangsklemmen (120, 120') der einen Phase und dem Nullleiter sensiert.

7. Vorrichtung nach Anspruch 6, **dadurch gekennzeichnet, dass** ein Signal betreffend eine Präsenz der mindestens einen Phase und des Nullleiters des allgemeinen Stromnetzes auf die DC-Leitungen (150, 151) der Schaltanordnung aufmoduliert ist, um an den Ausgangsklemmen (120, 120') eines Photovoltaikmoduls (110) abgreifbar vorzuliegen.

8. Vorrichtung nach Anspruch 4, **dadurch gekennzeichnet, dass** die Kipp-Schaltung (141) mit dem Ausgang des DC/AC-Wandlers (130) verbunden ist und bei einem Verlust an Potentialdifferenz zwischen den Ausgangsklemmen (120, 120') des DC/AC-Wandlers (130) ein Kippen der Schaltung in den zweiten Zustand bewirkt.

9. Vorrichtung nach Anspruch 4, **dadurch gekennzeichnet, dass** die Kipp-Schaltung (141) mit dem Ausgang des DC/AC-Wandlers (130) verbunden ist und eine Deaktivierung des DC/AC-Wandlers (130) über einen Verlust an Potentialdifferenz zwischen den Ausgangsklemmen (120, 120') des DC/AC-Wandlers (130) sensiert.

10. Vorrichtung nach einem der vorhergehenden Ansprüche, **dadurch gekennzeichnet, dass** die Schaltanordnung mindestens ein Schaltelement (141) enthält, das in einem ersten Zustand elektrischen Strom einer Ausgangsklemme (120, 120') eines Photovoltaikmoduls (110) mit einer Eingangsklemme des DC/AC-Wandlers (130) verbindet und in einem zweiten Zustand elektrischen Strom einer Ausgangsklemme (120, 120') eines Photovoltaikmoduls (110) mit dem Erdpotential verbindet.

11. Vorrichtung nach Anspruch 10, **dadurch gekennzeichnet, dass** jedem Photovoltaikelement (110) ein entsprechendes Schaltelement (141) zugeordnet ist.

12. Vorrichtung nach einem der vorhergehenden Ansprüche, **dadurch gekennzeichnet, dass** die Verbindung zur Erde (Erdpotential) über eine elektrische Verbindung (160) zu einem elektrisch leitenden Montagegestell der Photovoltaikmodule (110) hergestellt ist.

13. Vorrichtung nach einem der Ansprüche 10 bis 12, **dadurch gekennzeichnet, dass** das Schaltelement (141) von einem herkömmlichen elektrischen Relais gebildet ist.

14. Vorrichtung nach einem der Ansprüche 10 bis 12, **dadurch gekennzeichnet, dass** das Schaltelement (141) von einem Halbleiterschaltelement gebildet ist.

15. Vorrichtung nach Anspruch 14, **dadurch gekennzeichnet, dass** das Halbleiterschaltelement von einem Transistor gebildet ist.

16. Vorrichtung nach Anspruch 14, **dadurch gekennzeichnet, dass** das Halbleiterschaltelement von einem Tyristor gebildet ist.
